# EUROPEAN PATENT SPECIFICATION

(11) **EP 0 562 670 B1**
(45) Date of publication and mention of the grant of the patent: **02.06.1999**
(21) Application number: 93200757.8
(22) Date of filing: 16.03.1993
(51) Int. Cl.: H01J 9/14, H01J 17/49, B24C 1/04, B24C 3/32

(54) **Method of manufacturing a plate of electrically insulating material having a pattern of apertures and/or cavities for use in displays**
Verfahren zum Herstellen einer Platte aus einem elektrisch isolierenden Material mit einem Muster von Löchern oder Hohlräumen zum Gebrauch in Wiedergabeanordungen
Procédé de fabrication d'une plaque en matériau électriquement isolant pourvue d'une configuration de trous ou de creux et destinée à être utilisée dans des dispositifs de reproduction d'images

(30) Priority: 23.03.1992 EP 92200829; 16.02.1993 EP 93200420
(43) Date of publication of application: 29.09.1993
(73) Proprietor: Koninklijke Philips Electronics N.V., 5621 BA Eindhoven (NL)
(72) Inventor: De Haas, Franciscus Cupertinus Maria, NL-5656 AA Eindhoven (NL); Van Laarhoven, Franicscus Martinus Henricus, NL-5656 AA Eindhoven (NL); Van Beek, Johannes Gerardus, NL-5656 AA Eindhoven (NL)
(74) Representative: Koppen, Jan

(56) References cited:
- WO-A-91/12929
- US-A- 4 237 209
- US-A- 4 409 513
- PATENT ABSTRACTS OF JAPAN vol. 15, no. 86 (E-1039)28 February 1991 & JP-A-02 301 934 ( FUJITSU LTD. ) 14 December 1990
- IBM TECHNICAL DISCLOSURE BULLETIN. vol. 31, no. 12, May 1989, NEW YORK US pages 17 - 18 'Integrated control grids for CRTs'

## Description

The invention relates to a method of manufacturing a plate (1) of electrically insulating material having a plurality of cavities and/or apertures (3) arranged in a pattern, made by means of the following steps:
- producing at least one jet of abrasive powder particles;
- directing the jets(s) onto the surface of the plate;
- limiting the areas where the jet(s) impinge(s) upon the surface;
- performing a relative movement between the jet(s) and the plate, using a mask (2) in the form of a synthetic material, a metal plate or a synthetic material plate, which is temporarily stuck to the surface.

Plates of this type, which may particularly be made of hard, brittle materials such as glass or ceramic material, are particularly used in luminescent gas discharge displays such as plasma displays, in field emission displays, cathode ray displays and in displays in which electrons are propagated in ducts having walls of electrically insulating material (referred to as insulating electron duct displays) in which the apertures or cavities are used for manipulating electron currents. They may be formed as (multi-apertured) control plates and provided with (addressable) electrodes cooperating with the apertures, as transport plates having a plurality of parallel cavities (transport ducts), or as apertured spacers (for example, between a control plate and the luminescent screen of a luminescent display). Further, a use of (thin) wafers of electrically insulating material having a plurality of perforations is e.g. in pressure sensors.

US Patent 3,956,667 describes a luminescent gas discharge display. This display requires a control plate controlling the individual pixels. This control plate divides the inner space of such displays into two areas, a plasma area and a post-acceleration area. It comprises a perforated glass plate having an array of lines at one side and at the other side an array of columns of metal conductors or electrodes surrounding or extending along the perforations. These enable electrons to be selectively drawn from the plasma area through the apertures to the post-acceleration area and to be incident on the luminescent screen.

In the case of a control plate the number of perforations or apertures in a plate of the type described above is defined by the number of desired pixels.

Present-day television line scan patterns use, for example approximately 500 x 700 pixels having a horizontal pitch of 0.5 mm and a vertical pitch of 0.7 mm. These pixels define the pattern of apertures to be provided in the control plate of electrically insulating material. These apertures or perforations are conventionally provided by means of chemical etching (liquid etching, gas phase etching). However, when standard materials and chemical etching methods are used, the plate thickness, the aperture diameter and the pitch of the apertures cannot be chosen independently of each other. Moreover, if metal tracks are provided on the plate to be etched, there is the risk that underetching of the glass under the tracks may cause the tracks to come loose from the glass. It is also difficult to achieve the required accuracy in the use of chemical etching methods when the plates are relatively thick (thicker than approximately 200 microns, particularly thicker than 400 microns).

It is an object of the invention to provide a (preferably simple) method of manufacturing a plate which is particularly suitable for the uses described hereinbefore and offers the possibility of setting a large number of parameters for providing a desired pattern of cavities and/or apertures in coated (for example metallized) or uncoated plates of electrically insulating material.

As compared with etching processes, the use of a powder spraying process for making a pattern of apertures or cavities in a plate of electrically insulating material has the advantage that a large number of parameters is available, *inter alia,* the type of abrasive, grain size, diameter of the nozzle emitting the abrasive particles, nozzle/plate distance, pressure of the medium with which the powder particles are transported, movement of the nozzle, speed of the relative movement between nozzle and plate. By varying these parameters it has been found possible to make plates with a pattern of apertures and/or cavities which comply with the requirements imposed on the use in displays. The step of changing over from a chemical etching process to a powder spraying process for making patterns having a great many densely arranged apertures in electrically insulating plates for (electroluminescent) displays appears to lead to a number of advantages in the industrial manufacture of such devices.

Methods as described in the opening paragraph are known from JP-A-02 301 934, WO-A-9 112 929, US-A-4 237 209.

US-A-4 409 513 describes a method of making a three-dimensional grid aperture for use in an electrode of an electrode gun, comprising etching an electrically conductive base member from both sides.

These references describe methods in which cavities are made in an electrically insulating surface. However, the possibility of manufacturing different patterns is limited.

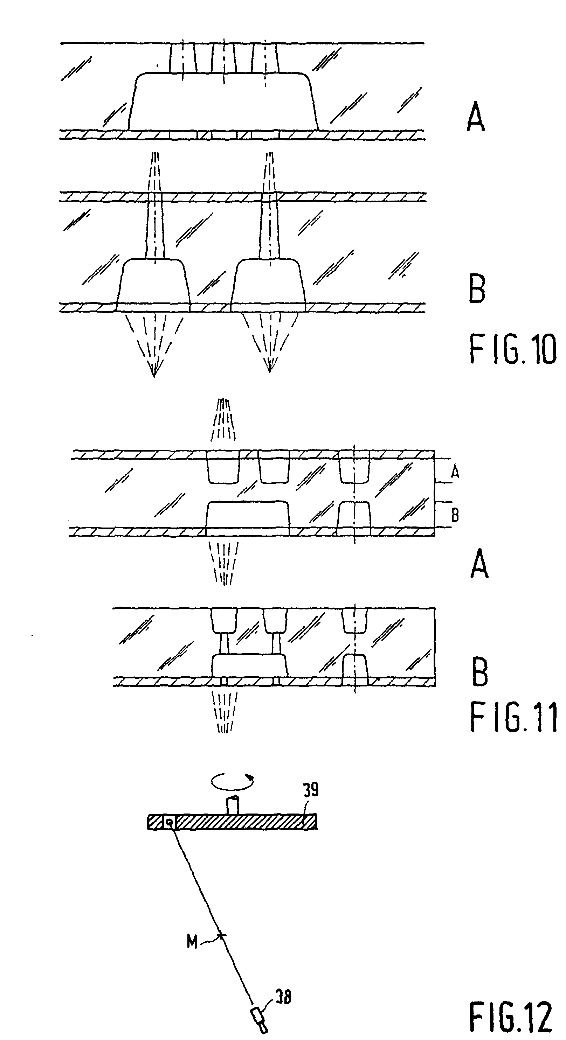

It is an object of the invention to provide a method in which a wider range of manufacturing possibilities is provided.
To this end the method according to the invention is characterized in that a pattern of cavities is provided in each of the facing surfaces of the plate, such that some cavities communicate with at least one cavity in an other surface than their own.
The cavities are provided in such a way that they communicate with one another, for example each cavity at one side communicates with one cavity (equally large as the first cavity, or different in size) at the other side (Fig. 10b). This provides the possibility of manufacturing "two plates in one". This results in a greater ease of handling during the manufacturing process.

The invention relates also to a method of manufacturing an electrically insulating plate according to the preamble of claims 3 and 4.

Such methods are known from JP-A-02 301 934, WO-A-9 112 929, US-A-4 237 209, US-A-4 409 513. These methods have the disadvantage that slightly tapered walls are obtained.

The object of the invention is to provide a method in which the tapering of the walls can be reduced. To this end the method according to a first embodiment of the invention is characterized in that the cavities and/or apertures having walls which are transverse to the plate surface are obtained by causing a nozzle, which is arranged obliquely to the surface, to rotate about a fixed point during the powder spraying process.
A second embodiment of the invention is characterized in that the cavities and/or apertures having walls which are transverse to the plate surface are obtained by using a plurality of stationary nozzles which are arranged in such a way that during the powder spraying process the object is sprayed from different directions at an angle to the normal on the object surface.

These and other aspects of the invention will be apparent from and elucidated with reference to the embodiments described hereinafter.

In the drawings
Fig. 1 is a cross-sectional view of a plate provided with a perforated mask;
Fig. 2 is a cross-sectional view of a perforated mask provided with a protective coating;
Fig. 3 is a cross-sectional view of a field emission display;
Figs. 9a, 9b and 9c show various patterns of apertures realised in this manner.

Electrically insulating control plates, transport plates and/or spacer plates having very accurate patterns of apertures and/or cavities are required for use in different types of (electroluminescent) displays. The plate thickness may be between 200 and 5000 microns, particularly between 200 and 700 microns. The depths of the apertures or cavities may range between 50 and 5000 microns. A characteristic material for these applications is glass or ceramic material.

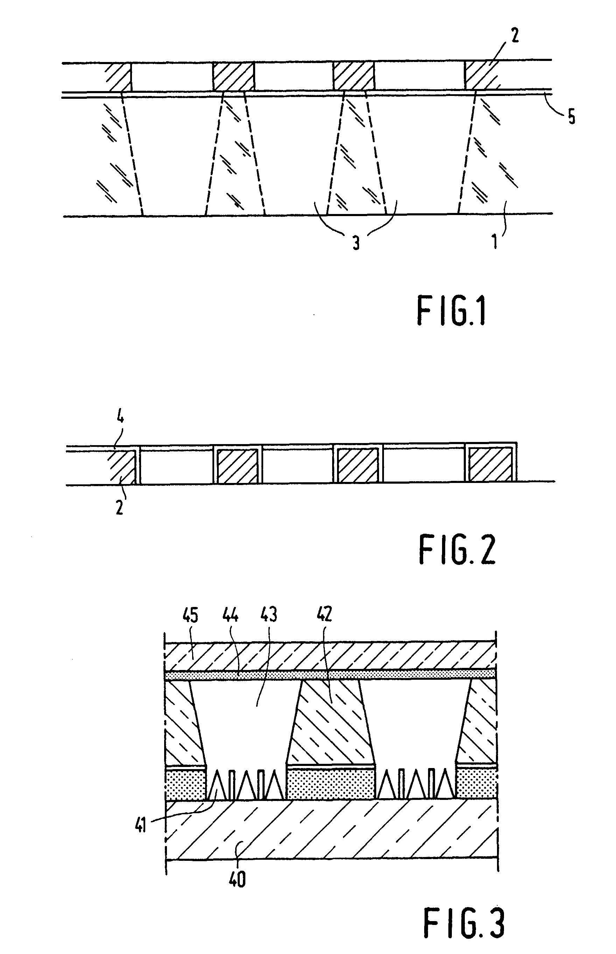

Fig. 1 is a cross-sectional view of such a plate 1 provided with a metal mask 2. Suitable metals are those which are easily etchable. A mask of Fe is slightly attacked by the abrasive powder spraying process used in accordance with the present invention to provide apertures 3 in the plate 1. An alternative material is (stainless) steel or an invar alloy (NiFe). Instead of a metal mask, which has the advantage that it can be used several times (for example, several dozen times), a lacquer mask (for example, a lacquer used in the silk-screening technique) or a synthetic material mask (for example, an UV-sensitive synthetic material) can be used.

The metal mask 2 may be provided with a protective coating 4 (Fig. 2) of, for example electrolytically provided nickel or chromium or of vapour-deposited aluminium. A coating of a synthetic material may alternatively be provided. A loose mask can be stuck on the plate 1 by means of an adhesive layer 5 so as to inhibit local detaching during the powder spraying process. The adhesive layer 5 may comprise an adhesive which is soluble in water (for example, an adhesive based on glucose). Such an adhesive can be easily provided at low cost and simply removed after use. The mask 2 may be alternatively made of a magnetic material and "stuck" to the plate 1 by means of a magnetic field.

The apertures 3 denoted by broken lines in the plate 1 are slightly tapered in the embodiment of Fig. 1. When plates are used as internal vacuum supports (spacer plates) in field emission displays, such an aperture shape is not unusual for making cylindrical apertures or cavities with parallel walls. Plates having cylindrical apertures are suitable, for example, as spacers between a control plate and the luminescent screen in an insulating electron duct display.

Fig. 3 is a diagrammatic cross-sectional view of a field emission display comprising a substrate 40, conical emission tips 41, a spacer plate 42 with apertures 43 and a front wall 45 with a luminescent screen 44. The spacer plate 42 may advantageously be made by means of the method according to the invention.

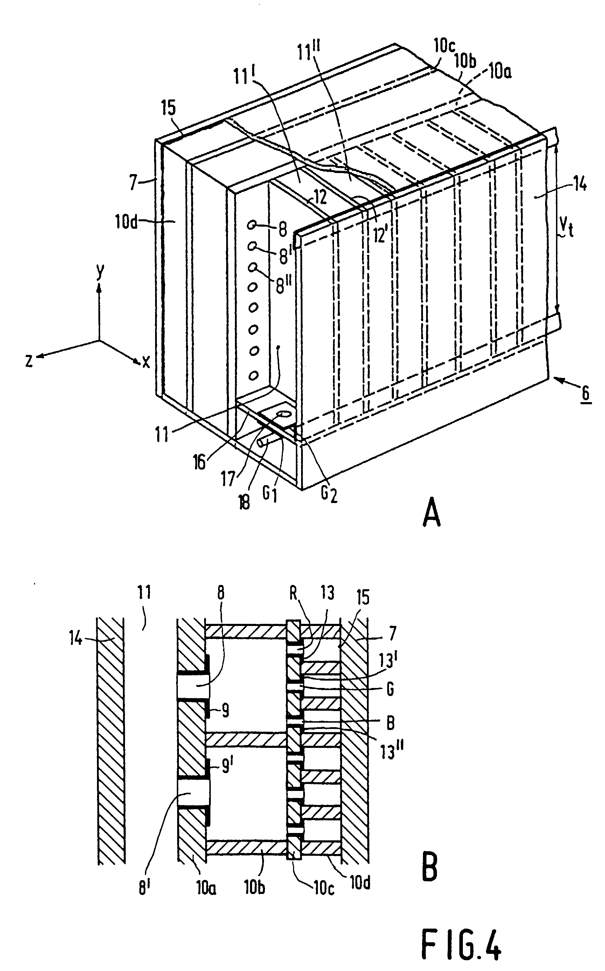

Fig. 4a is a diagrammatic elevational view and Fig. 4b is a cross-sectional view of an insulating electron duct display 6 as described in EP-A-400 750. This display comprises a plurality of insulator plates 10a, 10b, 10c, 10d having regular aperture patterns between a transparent face plate 7 and a rear wall 14.

A luminescent screen 15 is provided on the inner surface of the face plate 7. A flu-spacer plate 10d having a characteristic thickness of approximately 1 mm and, for example 1 x 10⁶ apertures corresponding to the number of luminescent areas (colour dots) on the screen 15 is adjacent to this luminescent screen. The colour dots are addressed by means of a preselection plate 10a and a fine-selection plate 10c each of, for example glass and being 0.5 mm thick. The plate 10c has a pattern of aperture triplets R, G, B in this case. The apertures in the plate 10c are activated, for example row by row by means of metal fine-selection electrodes 13, 13', 13'', .... These electrodes may be provided after the apertures have been made, which provides the possibility of metallizing the walls of the apertures as well. An alternative method is to provide the fine-selection electrodes in advance. Preselection plate 10a is separated from fine-selection plate 10c by a spacer structure 10b, in this case a plate having (large) apertures connecting each one of, for example 350,000 apertures 8, 8', ... in the preselection plate 10a with a plurality of apertures in the fine-selection plate 10c. The preselection plate 10a is provided with preselection electrodes 9, 9', ... for activating, for example row by row the apertures 8, 8', ... communicating with electron transport ducts 11, 11', 11'', ... (see also Fig. 4a). The transport ducts 11, 11', 11'', ... are separated from each other in this case by electrically insulating partitions 12, 12', 12", .... An alternative method is to provide the transport ducts (a total number of several hundred, for example 200 or 400) as duct-shaped cavities having a depth of several mm and a width of, for example 0.5 or 1 mm in the rear wall 14. The method according to the invention is also applicable for this purpose. The rear wall 14 constitutes an electron transport plate in this case. The transport ducts 11, 11', 11", ... cooperate, *via* a perforated cathode plate 16 (of, for example 1 mm thick glass) with a - line-shaped - electron source 18. The apertures 17 in the cathode plate 16 (also several hundred, for example 200 or 400) may also be provided advantageously by means of the method according to the invention.

In connection with the large number of perforated, relatively thick plates (at least four), the very large numbers of apertures, the necessity of a continuous or strip-shaped coating on a plurality of these plates, the invention also provides a solution when manufacturing "insulating electron duct displays" of the type shown in Figs. 4a and 4b on an industrial scale.

Fig. 5 is an elevational view of a gas discharge display as described in DE-2 412 869. This display has an insulator plate 21 provided with a regular pattern of apertures 22. Row conductors 23 extend at one side across the apertures 22. These conductors are provided by means of, for example a printing technique, vapour deposition or photolithography. Column conductors 24 extend across the other side of the apertures 22. DE-2 412 869 is referred to for the operation of such a display. The insulator plate 21 may advantageously be made by means of the method according to the invention.

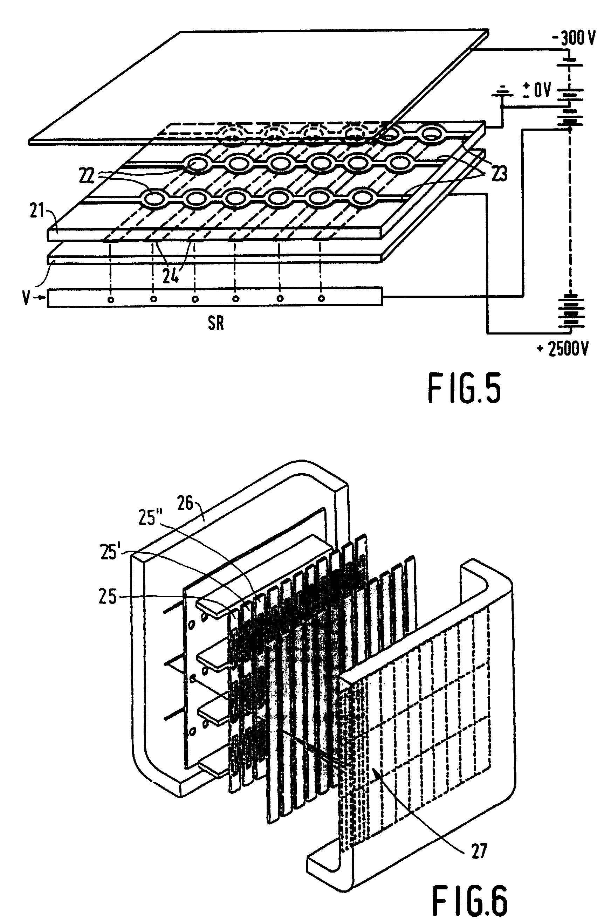

Fig. 6 is an elevational view of a flat panel display as presented in publications by MEI. This display comprises a large number of metal electron beam control electrodes 25, 25', 25'', ... provided with slotted apertures between a rear wall 26 and a luminescent screen 27. These electrodes can be provided by means of the invention on a plate of electrically insulating material having the same aperture pattern, which has great advantages as regards ease of handling and suspension.

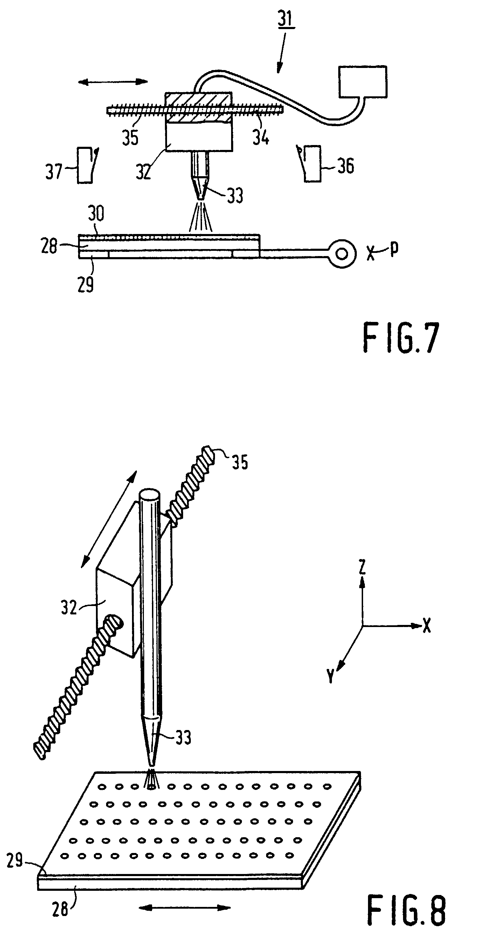

Fig. 7 shows a plate 28 to be sprayed, which plate is positioned on a support 29. The support 29 is movable in the direction of the arrow P perpendicular to the plane of the drawing. The plate 28 is provided with a mask 30 having the shape of a perforated metal plate. In this example the mask 30 has a regular pattern of circular apertures (see Fig. 8). A device 31 for performing an abrasive operation (powder spraying device) is shown diagrammatically as a spraying unit 32 having a nozzle 33 directed onto the surface of the plate 28. Dependent on whether apertures or cavities are to be made, the nozzle/mask distance may range between 0.5 and 25 cm, typically between 2 and 10 cm. During operation a jet of abrasive powder particles, for example silicon carbide particles, aluminium oxide particles, granulated glass or steel or mixtures thereof is blown from the nozzle 33. A pressure principle or a venturi principle may be used for this purpose. Abrasive particle dimensions suitable for the object of the invention range between 1 and 200 microns, typically between 10 and 100 microns.

In this embodiment spraying unit 32 with nozzle 33 can be traversed in a direction transverse to the arrow P by means of a traversing device 34 which has a spindle 35.

Stops provided with electric contacts are denoted by the reference numerals 36 and 37 and are assumed to be connected to a reversing circuit so as to reverse the sense of rotation of the spindle 35 to be driven by a motor.

During operation the support 29 and the plate 28 make a, for example reciprocating movement parallel to the X axis and the spraying unit 32 performs axial traversing movements parallel to the Y axis (Fig. 8), the speeds of movement being adapted to each other in such a way that the complete desired aperture or cavity pattern is obtained in the plate 28. Instead of one nozzle it is possible (for example, for the purpose of accelerating the process) to use a number of nozzles for spraying areas which are spaced apart, are tangent to each other, or partially or completely overlap each other.

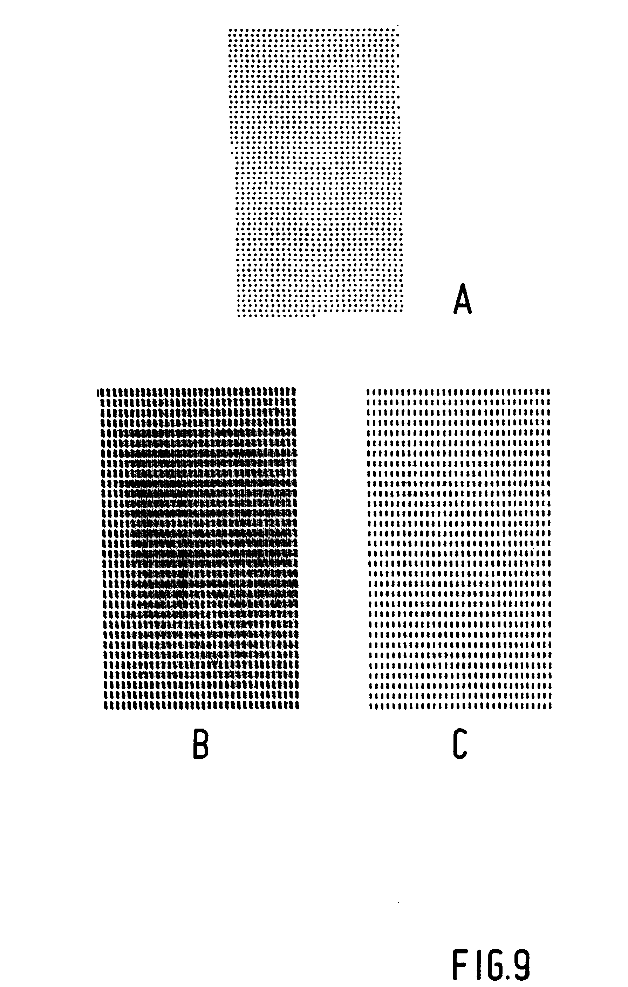

Fig. 9a shows in real size a part of a pattern of circular apertures obtained in this manner.

Figs. 9b and 9c show patterns of slotted apertures obtained in similar manners.

A 0.5 mm thick plate of 30 x 40 cm can be provided with a very accurate aperture pattern of 1 x 10⁶ apertures having a diameter of 600 microns within 5 minutes in the manner described above.

For insulating electron duct displays of the Fig. 4 type, four perforated plates are required, with aperture patterns having a number of apertures varying between 100 x 10³ and 10 x 10⁶.

The invention may alternatively be used for providing a large number of parallel elongate cavities in a plate of electrically insulating material, which cavities are used as electron transport ducts in an insulating electron duct display. The display shown in Fig. 4a comprises several hundred (for example, 400) of such electron transport duct cavities 11, 11', 11'', ... *etc*.

The invention is not only suitable for unilaterally providing a pattern of apertures or cavities but also for providing patterns of cavities at both sides. The cavities can be provided in such a way that they communicate with one another, for example each cavity at one side communicates with two or more cavities at the other side (Fig. 10a) or each cavity at one side communicates with one cavity (equally large as the first cavity, or different in size) at the other side (Fig. 10b). This provides the possibility of manufacturing "two plates in one". This results in a greater ease of handling during the manufacturing process.

Figs. 11a and 11b show how "three plates in one" can be made. First, a sub-pattern of cavities is made in each one of the facing surfaces of the plate, which cavities do not communicate with one another (Fig. 11a). In a subsequent powder spraying step, in which a mask arranged on one of the surfaces is used, corresponding cavities are connected to each other by providing perforations (Fig. 11b).

It is to be noted that duct-shaped cavities, as previously mentioned in connection with the construction of Fig. 4, can be made without using a mask, for example by producing at least one localized powder jet and by moving it once or a number of times across the plate at the location where the duct is to be made.

If the powder spraying process is performed at a relatively high speed ("high-speed spraying"), it is recommendable to cool the metal mask by cooling, for example the glass plate by means of a flow of liquid. Heating of the metal mask may alternatively be inhibited by using a synthetic material coating which ensures that the powder particles not passing through the apertures rebound more or less elastically.

In the powder spraying process the shaping of the apertures may be enhanced if the plate to be sprayed is supported by a plate having a pattern of apertures which is exactly located under the aperture pattern to be sprayed. The plate to be sprayed may alternatively be supported at its edges only, at locations where it is not apertured.

When using a nozzle which is substantially perpendicular to the plate surface, apertures having slightly tapering walls will be obtained. Dependent on the geometries used, the walls may extend at an angle of between several degrees and 20 degrees to the normal on the plate surface. The taper may be limited by performing the abrasion process from both plate surfaces.

Apertures (and cavities) having walls which are transverse to the plate surface can be obtained within the scope of the invention by causing a nozzle, which is arranged obliquely to the surface, to rotate about a fixed point during the powder spraying process so that it describes, for example, a surface of a cone. To this end the nozzle (the spray pipe) 38 can be placed in a holder having a point of rotation M and rotated with the aid of a template arranged above this holder. See Fig. 12.

An alternative to the above-mentioned method is the use of a plurality of stationary nozzles which are arranged in such a way that during the powder spraying process the object is sprayed from different directions at an angle to the normal on the object surface. Suitable results were achieved, for example, with six nozzles placed at the vertices of a regular hexagon, with each nozzle in a plane parallel to one of the sides of the hexagon and extending at an angle α to the normal on the object surface. In most cases an angle α of between 10° and 50° was satisfactory for obtaining cavities and/or apertures having walls extending transversely to the object surface.

Plates manufactured by using the inventive method may contain at least one and in most cases a very large number of holes (and/or cavities) which are placed close together so that they constitute at least approximately 30% or even more than approximately 50% of the exposed surface area of the plate. As mentioned already areas of utility are amongst others various types of electronic displays where plates having arrays of e.g. one hundred thousand, several hundred thousands, or more holes are utilized to control electron propagation. Other areas of utility are e.g. electron tubes of the image intensifier type where the output electrons are directed towards a phosphor surface which emits light upon being struck by electrons, or where the output electrons are being utilized directly, e.g. for the exposure of a photographic film.

## Claims

1. A method of manufacturing a plate (1) of electrically insulating material having a plurality of cavities and/or apertures (3) arranged in a pattern, made by means of the following steps:
- producing at least one jet of abrasive powder particles;
- directing the jets(s) onto the surface of the plate;
- limiting the areas where the jet(s) impinge(s) upon the surface;
- performing a relative movement between the jet(s) and the plate, using a mask (2) in the form of a synthetic material, a metal plate or a synthetic material plate, which is temporarily stuck to the surface of the plate to limit the areas where the jet(s) impinge(s) upon the surface, characterized in that a pattern of cavities is provided in each of the facing surfaces of the plate, such that some cavities in one facing surface communicate with at least one cavity in the other facing surface.

2. A method as claimed in claim 1, characterized in that a sub pattern of cavities is provided in each of the facing surfaces of the plate and in that corresponding cavities are connected together by perforations which are provided in a subsequent step of the method.

3. A method of manufacturing a plate (1) of electrically insulating material having a plurality of cavities and/or apertures (3) arranged in a pattern, made by means of the following steps:
- producing at least one jet of abrasive powder particles;
- directing the jet(s) onto a surface of the plate;
- limiting the areas where the jet(s) impinge(s) upon the surface ;
- performing a relative movement between the jet(s) and the plate characterized in that the cavities and/or apertures having walls which are transverse to the plate surface are obtained by causing a nozzle, which is arranged obliquely to the surface, to rotate about a fixed point during the powder spraying process.

4. A method of manufacturing a plate (1) of electrically insulating material having a plurality of cavities and/or apertures (3) arranged in a pattern, made by means of the following steps:
- producing at least one jet of abrasive powder particles;
- directing the jet(s) onto a surface of the plate;
- limiting the areas where the jet(s) impinge(s) upon the surface ;
performing a relative movement between the jet(s) and the plate characterized in that the cavities and/or apertures having walls which are transverse to the plate surface are obtained by using a plurality of stationary nozzles which are arranged in such a way that during the powder spraying process the object is sprayed from different directions at an angle to the normal on the object surface.

## Patentansprüche

1. Verfahren zum Herstellen einer Platte (1) aus elektrisch isolierendem Material mit einer Anzahl in einem Muster gegliederter Hohlräume und/oder Löcher (3), wobei diese Platte nach den folgenden Verfahrensschritten hergestellt wird:
- das Erzeugen wenigstens eines Strahles Scheuerpulverteilchen;
- das Ausrichten des Strahles bzw. der Strahlen auf die Oberfläche der Platte;
- das Beschränken der Gebiete, wo der Strahl bzw. die Strahlen die Oberfläche trifft bzw. treffen;
- das Durchführen einer relativen Bewegung zwischen dem Strahl bzw. den Strahlen und der Platte, wobei eine Maske (2) aus Kunststoffmaterial, eine Metallplatte oder eine Kunststoffplatte verwendet wird, die vorübergehend auf der Oberfläche der Platte befestigt ist zur Beschränkung der gebiete, wo der Düsenstrahl bzw. die Düsenstrahlen auf die Oberfläche trifft bzw. treffen, dadurch gekennzeichnet, dass in jeder der einander zugewandten Oberflächen der Platte ein Muster von Hohlräumen derart vorgesehen wird, dass einige Hohlräume in der einen Fläche der einander zugewandten Flächen mit wenigstens einem Hohlraum in der anderen Fläche der einander zugewandten Flächen in Verbindung stehen.

2. Verfahren nach Anspruch 1, dadurch gekennzeichnet, dass ein Hilfsmuster von Hohlräumen in jeder der einander zugewandten Flächen der Platte vorgesehen ist und dass entsprechende Hohlräume durch Perforationen miteinander verbunden sind, die in einem nachfolgenden Verfahrensschritt vorgesehen werden.

3. Verfahren zum Herstellen einer Platte (1) aus elektrisch isolierendem Material mit einer Anzahl in einem Muster gegliederter Hohlräume und/oder Löcher (3), wobei diese Platte nach den folgenden Verfahrensschritten hergestellt wird:
- das Erzeugen wenigstens eines Strahles Scheuerpulverteilchen;
- das Ausrichten des Strahles bzw. der Strahlen auf die Oberfläche der Platte;
- das Beschränken der Gebiete, wo der Strahl bzw. die Strahlen die Oberfläche trifft bzw. treffen;
- das Durchführen einer relativen Bewegung zwischen dem Strahl bzw. den Strahlen und der Platte, dadurch gekennzeichnet, dass die Hohlräume und/oder die Öffnungen mit Wänden, die durch die Plattenoberfläche hindurchgehen, dadurch erhalten werden, dass eine Düse, die gegenüber der Oberfläche schräg angeordnet ist, während des Pulverstrahlverfahrens um einen festen Punkt in Drehung versetzt wird.

4. Verfahren zum Herstellen einer Platte (1)
aus elektrisch isolierendem Material mit einer Anzahl in einem Muster gegliederter Hohlräume und/oder Löcher (3), wobei diese Platte nach den folgenden Verfahrensschritten hergestellt wird:
- das Erzeugen wenigstens eines Strahles Scheuerpulverteilchen;
- das Ausrichten des Strahles bzw. der Strahlen auf die Oberfläche der Platte;
- das Beschränken der Gebiete, wo der Strahl bzw. die Strahlen die Oberfläche trifft bzw. treffen;
- das Durchführen einer relativen Bewegung zwischen dem Strahl bzw. den Strahlen und der Platte, dadurch gekennzeichnet, dass die Hohlräume und/oder die Öffnungen mit Wänden, die sich durch die Plattenoberfläche hindurch erstrecken, dadurch erhalten werden, dass eine Anzahl ortsfester Düsen verwendet werden, die derart angeordnet sind, dass während des Pulverstrahlvorgangs der Gegenstand von verschieden Richtungen aus in einem Winkel mit der Normalen auf der Oberfläche des Gegenstandes bestrahlt wird.

## Revendications

1. Procédé pour fabriquer une plaque (1) en matériau électriquement isolant présentant une pluralité de creux et/ou de trous (3) disposés dans une configuration réalisée à l'aide des étapes suivantes:
- la production d'au moins un jet contenant des particules de poudre abrasives;
- l'orientation du (des) jet(s) sur la surface de la plaque;
- la limitation de zones où le(s) jet(s) frappe(nt) la surface;
- la réalisation d'un mouvement relatif entre le(s) jet(s) et la plaque à l'aide d'un masque (2) en forme d'un matériau synthétique, d'une plaque métallique ou d'une plaque en matériau synthétique qui s'adhère temporairement à la surface de la plaque pour limiter les zones où le(s) jet(s) frappe(nt) la surface, caractérisé en ce qu'une configuration de creux est prévue dans chacune des surfaces en regard de la plaque de façon que quelques creux présents dans une surface en regard communiquent à au moins un creux présent dans l'autre surface.

2. Procédé selon la revendication 1, caractérisé en ce qu'une sous-configuration de creux est réalisée dans chacune des surfaces en regard de la plaque et en ce que des creux correspondants sont reliés l'un à l'autre par des perforations qui sont pratiquées dans une étape subséquente du procédé.

3. Procédé pour fabriquer une plaque (1) en matériau électriquement isolant présentant une pluralité de creux et/ou de trous (3) disposés dans une configuration réalisée à l'aide des étapes suivantes:
- la production d'au moins un jet contenant des particules de poudre abrasives;
- l'orientation du (des) jet(s) sur une surface de la plaque;
- la limitation de zones où le(s) jet(s) frappe(nt) la surface;
- la réalisation d'un mouvement relatif entre le(s) jet(s) et la plaque, caractérisé en ce que l'on obtient les creux et/ou les trous présentant des parois qui sont transversales à la surface de plaque en faisant tourner une tuyère, qui est disposée obliquement par rapport à la surface, autour d'un point fixe pendant le processus de pulvérisation de poudre.

4. Procédé pour fabriquer une plaque (1) en matériau électriquement isolant présentant une pluralité de creux et/ou de trous (3) disposés dans une configuration réalisée à l'aide des étapes suivantes:
- la production d'au moins un jet contenant des particules de poudre abrasives;
- l'orientation du (des) jet(s) sur une surface de la plaque;
- la limitation de zones où le(s) jet(s) frappe(nt) la surface;
- la réalisation d'un mouvement relatif entre le(s) jet(s) et la plaque, caractérisé en ce que l'on obtient les creux et/ou les trous présentant des parois qui sont transversales à la surface de plaque en utilisant une pluralité de tuyères stationnaires qui sont disposées de façon que pendant le processus de pulvérisation de poudre l'objet soit pulvérisé sur la surface d'objet à partir de directions différentes sous un angle par rapport à la normale.
